Europäisches Patentamt

European Patent Office

Office européen des brevets

(11) Publication number: **0 316 165**
**A2**

# (12) EUROPEAN PATENT APPLICATION

(21) Application number: **88310576.9**

(22) Date of filing: **10.11.88**

(51) Int. Cl.⁴: **H 01 L 21/76**
**H 01 L 21/265**

(30) Priority: **11.11.87 JP 284856/87**

(43) Date of publication of application:
**17.05.89 Bulletin 89/20**

(84) Designated Contracting States: **DE FR GB**

�['71] Applicant: **SEIKO INSTRUMENTS INC.**
**31-1, Kameido 6-chome Koto-ku**
**Tokyo 136 (JP)**

�[72] Inventor: **Hosakao, Takashi**
**c/o Seiko Instruments Inc. 31-1 Kameido 6-chome**
**Koto-ku Tokyo (JP)**

�['74] Representative: **Caro, William Egerton et al**
**J. MILLER & CO. Lincoln House 296-302 High Holborn**
**London WC1V 7JH (GB)**

(54) A method of trench isolation.

㊼ A method of trench isolation comprising the steps of forming an ion implanted layer (4) in a region of a semi-conductor substrate (1) and providing a trench (5) in the ion implanted layer.

FIG.1b

**Description**

# A METHOD OF TRENCH ISOLATION

This invention relates to methods of manufacturing semi-conductor devices, and particularly to methods of trench isolation.

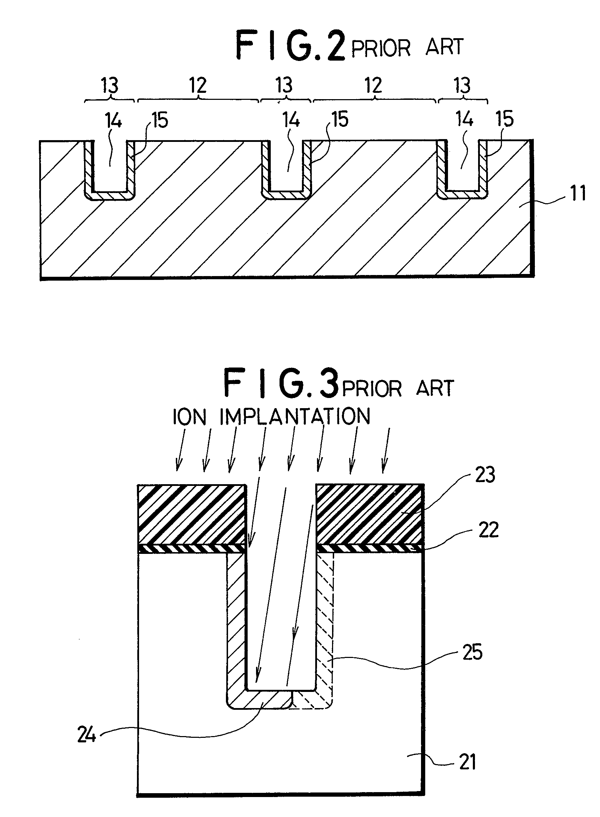

With miniaturisation of semi-conductor devices isolation regions have to be made smaller and smaller. In the line with this trend, trench isolation has recently been proposed and has been under development. In trench isolation, as shown in Figure 2, trenches 14 are formed in a semi-conductor substrate 11 to serve as isolation regions 13 in order electrically to isolate active areas 12 in which devices, such as transistors, are formed. Isolation capacity increases with increase of the depth of the trench 14. In order to improve the isolation capacity and to prevent the inversion of polarity, the impurity concentration of the semi-conductor substrate 11 at the isolation regions 13 is generally made higher than that of the active areas 12. This region 15 is called a field dope region. Generally, the field dope region 15 is formed by ion implantation after the trenches have been formed. However, when the trench is relatively deep, a part of the trench is not implanted with ions. As shown in Figure 3, because the incident angle of ions during ion implantation is 7° in order to prevent the channelling phenomenon, ions are consequently blocked by a masking resist 23 and an insulation film 22 formed on the surface of a substrate 21 in which the trench is to be formed during ion implantation -this phenomenon is called the shadowing effect - and, whilst a part 24 of the trench is implanted with ions a part 25 is not.

A rotating ion implantation method is used in order to prevent the shadowing effect. However, this method requires complex apparatus, and the control of the apparatus is extremely difficult.

There is another method called "zero degree ion implantation method", in which ions are implanted vertically relative to the surface of the semi-conductor substrate 21. However, the drawback of this method is that it is difficult to implant in the walls of the trench.

Besides these ion implantation methods, a diffusion method may be used, in which a film containing an impurity is formed on the walls of a trench after the trench has been formed, and the impurity is diffused from the film into the walls of the trench. However, this method requires complicated steps. Further, since the amount of impurity required for field doping is at most $10^{16}$ - $10^{18}$ /cm$^3$, it is difficult to control the impurity concentration at this low level by the diffusion method.

As will be appreciated from the above, it is extremely difficult for the conventional methods of trench isolation uniformly to dope the walls of a trench with a desired impurity concentration, and therefore it is almost impossible to obtain stable isolation characteristics.

The present invention seeks to provide a method of trench isolation in which a trench is formed after an impurity dope layer has been formed in a substrate by ion implantation. The present invention also seeks to provide a method to form impurity doped walls of a trench in a trench isolation device. Furthermore, the present invention seeks to provide a method of trench isolation which produces a graded doping profile or a uniform doping profile along the side walls of a trench.

According to a present invention there is provided a method of trench isolation characterised by the steps of forming an ion implanted layer in a region of a semi-conductor substrate, and providing a trench in said ion implanted layer.

Preferably said step of forming the ion implanted layer comprises the steps of forming an insulation film on the semi-conductor substrate, depositing a photo-resist with a window in the region where the trench is to be formed, etching said insulation film, forming the ion implanted layer in the area confined by the window by ion implantation with ion energy ranging from a relatively low energy level to a relatively high energy level.

The step of forming the ion implanted layer may comprise the step of changing the acceleration energy for ion implantation between a relatively low energy level and a relatively high energy level for providing a desired doping profile for the trench.

The step of forming the ion implanted layer may comprise the step of controlling the amount of implanting ions to provide either a substantially vertically uniform doping profile or a substantially vertically graded doping profile at the region of the semi-conductor substrate where the trench is to be provided.

The method may be characterised by using a material having a high capacity to prevent ions passing therethrough as a mask for ion implantation.

Preferably the step of ion implanting is carried out at an implantation angle of ± 5° or less from a normal to the surface of the semi-conductor substrate.

The invention is illustrated, merely by way of example, in the accompanying drawings, in which:-

Figure 1, consisting of Figures 1a to 1f, shows, in section, the steps of manufacturing a semi-conductor device using a method according to the present invention of trench isolation;

Figure 2 shows, in section, a prior art semi-conductor device; and

Figure 3 illustrates the shadowing effect during conventional ion implantation of a semi-conductor device.

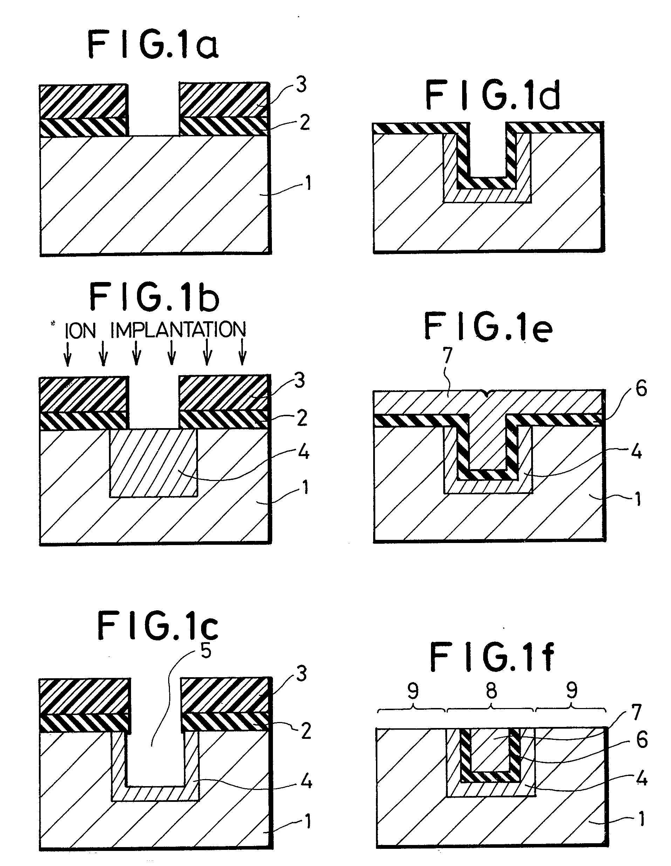

An embodiment of a method according to the present invention of trench isolation will be described in detail with reference to Figure 1. As shown in Figure 1a, an insulation film 2 is provided on a semi-conductor substrate 1. The semi-conductor substrate 1 may be comprised of silicon (Si), germanium (Ge), gallium arsenide (GaP), indium phosphide (InP), gallium phosphide (GaP), etc. The insulation film 2 may be comprised of a silicon dioxide (SiO$_2$) film formed by thermal oxidation in the case of silicon, or an insulation film deposited by chemical vapour deposition (CVD).

Thereafter, a photo-resist 3 is applied thereon, and a window is provided where an isolation area is to be formed, and the insulation film 2 is then etched away using the photo-resist 3 as a mask. For the etching of the insulation film 2, either dry etching or wet etching can be used.

As shown in Figure 1b, using a high energy ion implantation apparatus (not shown), the semi-conductor substrate 1 is ion implanted through the window with impurity ions such as phosphorous (P), arsenic (As), antimony (Sb), boron (B), etc. This ion implantation causes the semi-conductor substrate 1 to be implanted with ions from its surface to a depth adjacent to the bottom of a trench to be formed later. In this case, the ion energy for ion implantation is varied from a low ion energy level to 10 - 30 KeV to a high ion energy level with which ions can be implanted to a depth of several microns. For example, a 5 micron deep boron implantation into a silicon substrate requires an acceleration energy of 3 MeV. Further, the amount of implanting ions may be controlled according to the requirements to provide either a vertically uniform doping profile or a vertically graded doping profile. The ion implantation can be carried out by gradually increasing the acceleration energy from a low energy level to a high energy level, or by decreasing the energy from a high energy level to a low energy level. Of course, the acceleration energy can be changed according to a desired sequence.

A layer of the insulation film 2 and the photo-resist 3, which serves as a mask for ion implantation, should have a sufficient thickness to stop the penetration of ions into the semi-conductor substrate 1 when the ion implantation is carried out with a maximum energy. It is, of course, possible to reduce the total thickness of the layer by inserting, between the insulation film 2 and the photo-resist 3, a material having a large capacity to stop ions. On the other hand, impurity ions implanted at a high energy level may be intentionally introduced into the semi-conductor substrate 1 thereby forming, for example, a well in the semi-conductor substrate.

As shown in Figure 1c, by anisotropic etching such as reactive ion etching, a trench 5 having a desired depth is formed still using the insulation film 2 and the photo-resist 3 as a mask. Even when the side walls of the trench are etched away relative to the window of the mask, the horizontal diffusion of impurity ions is generally large and therefore, as shown in Figure 1c, the trench 5 is surrounded by a field dope layer 4.

It is also possible to provide a trench 5 by the following steps: ion implantation is carried out as shown in Figure 1b, the photo-resist 3 is removed, annealing is carried out to diffuse implanted ions to some degree, and the trench 5 is formed. In this case, the insulation film 2 is used as a mask for etching.

After the formation of the trench 5, the steps carried out thereafter are the same as those used in conventional methods of trench isolation. For example, as shown in Figure 1d, after the insulation film 2 is removed, the semi-conductor substrate 1 is oxidized to form a layer 6. The oxidation may be carried out in a manner that the etched corners are rounded. Then as shown in Figure 1e, a poly-crystal silicon layer 7 is deposited thereon by CVD during which the trench 5 is filled with poly-crystal silicon. Of course, instead of poly-crystal silicon, other materials can be used to fill the trench. The surface of the semi-conductor substrate 1 is made planar by etching as shown in Figure 1f, thereby to form an isolation area 8 and an active area 9. In the active areas, semi-conductor devices, etc. are formed in later steps.

An important point of the present invention resides in the ion implantation step. Ions are implanted in a semi-conductor substrate from its surface to a given depth. For such ion implantation, either a single ion implantation apparatus or several ion implantation apparatus may be used. In the latter case, an ion implantation apparatus suitable for low energy acceleration is used in combination with a ion implantation apparatus suitable for high energy acceleration.

As long as the field dope layer 4 and the trench 5 can be formed, the insulation film 2 used in the step shown in Figure 1 can be omitted.

The mask to be used needs to be thicker, as the depth of the ion implanted layer or the depth of the trench 5 becomes deeper, then the shadowing effect may be a problem during ion implantation. The solution to this is to reduce the thickness of the mask by inserting a material having a large capacity to stop ions, or to carry out "zero degree ion implantation", the ion implantation being carried out as vertically as possible relative to the surface of the semi-conductor substrate. When the channelling effect is to be prevented during zero degree ion implantation, the ion implantation is carried out after the semi-conductor substrate has been covered with a thin insulation film. Since the trench 5 is formed after ion implantation, there is little chance that the field dope layer is not formed on all the walls of the trench, and the field dope layer can be provided with a desired impurity concentration.

Apart from use in the manufacture of semi-conductor devices as described above, it will be appreciated that the present invention is applicable to the manufacture of trench capacitors.

## Claims

1. A method of trench isolation characterised by the steps of forming an ion implanted layer (4) in a region of a semi-conductor substrate (1), and providing a trench in said ion implanted layer.

2. A method as claimed in claim 1 characterised in that said step of forming the ion implanted layer (4) comprises the steps of forming an insulation film (2) on the semi-conductor substrate (1), depositing a photo-resist (3) with a window in the region where the trench (5) is to be formed, etching said insulation film (2), forming the ion implanted layer in the area confined by the window by ion implantation with ion energy ranging from a relatively low energy level to a relatively high energy level.

3. A method as claimed in claim 2 characterised in that the step of forming the ion implanted layer comprising the step of changing the acceleration energy for ion implantation between a relatively low energy level and a relatively high energy level for providing a desired doping profile for the trench (5).

4. A method as claimed in claim 2 or 3, characterised in that the step of forming the ion implanted layer comprises the step of controlling the amount of implanting ions to provide either a substantially vertically uniform doping profile or a substantially vertically graded doping profile at the region of the semi-conductor substrate where the trench (5) is to be provided.

5. A method as claimed in any preceding claim characterised by using a material having a high capacity to prevent ions passing therethrough as a mask for ion implantation.

6. A method as claimed in any of claims 2 to 5 characterised in that the step of ion implanting is carried out at an implantation angle of $\pm$ 5° or less from a normal to the surface of the semi-conductor substrate (1).

# FIG.1a

# FIG.1b

ION  IMPLANTATION

# FIG.1c

# FIG.1d

# FIG.1e

# FIG.1f

# F I G.2 PRIOR ART

13  12  13  12  13
14  15  14  15  14  15

11

# F I G.3 PRIOR ART

ION IMPLANTATION

23

22

25

24

21